# EUROPEAN PATENT SPECIFICATION

(11) **EP 4 156 232 B1**
(45) Date of publication and mention of the grant of the patent: **10.09.2025**
(21) Application number: 22190629.0
(22) Date of filing: 16.08.2022
(51) Int. Cl.: H01L 21/28, H10B 53/30, H10D 1/68

(54) **MEMORY DEVICES WITH NITRIDE-BASED FERROELECTRIC MATERIALS**
SPEICHERANORDNUNGEN MIT FERROELEKTRISCHEN MATERIALIEN AUF NITRIDBASIS
DISPOSITIFS DE MÉMOIRE À MATÉRIAUX FERROÉLECTRIQUES À BASE DE NITRURE

(30) Priority: 24.09.2021 US 202117485305
(43) Date of publication of application: 29.03.2023
(73) Proprietor: INTEL Corporation, Santa Clara, CA 95054 (US)
(72) Inventor: KARPOV, Elijah V., Portland, OR 97229 (US); AVCI, Uygar E., Portland, OR 97225 (US); SHIVARAMAN, Shriram, Portland, OR 97229 (US); CHANG, Sou-Chi, Portland, OR 97229 (US)
(74) Representative: HGF

(56) References cited:
- CN-A- 113 380 825
- CN-A- 113 421 885
- US-A1- 2020 290 865
- US-A1- 2021 151 445
- US-A1- 2021 398 990
- WANG DIXIONG ET AL: "Ferroelectric Switching in Sub-20 nm Aluminum Scandium Nitride Thin Films", IEEE ELECTRON DEVICE LETTERS, IEEE, USA, vol. 41, no. 12, 28 October 2020 (2020-10-28), pages 1774 - 1777, XP011822054, ISSN: 0741-3106, [retrieved on 20201123], DOI: 10.1109/LED.2020.3034576

## Description

### TECHNICAL FIELD

Embodiments of the disclosure are in the field of advanced integrated circuit structure fabrication and, in particular, memory devices with nitride-based ferroelectric materials.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 10 nanometer node or sub-10 nanometer node range. Consequently, fabrication of the functional components needed for future technology nodes may require the introduction of new methodologies or the integration of new technologies in current fabrication processes or in place of current fabrication processes.

In the manufacture of integrated circuit devices, multi-gate transistors, such as tri-gate transistors, have become more prevalent as device dimensions continue to scale down. Tri-gate transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

Document CN 113421885A discloses a memory device, a transistor and a method of fabricating the same, the memory device including a Ferroelectric (FE) structure and a top electrode layer, the ferroelectric structure including a dielectric layer, a ferroelectric layer disposed on the dielectric layer, and an interface metal layer disposed on the ferroelectric layer, wherein the interface metal layer includes tungsten (W), molybdenum (Mo), ruthenium (Ru), tantalum nitride (TaN), or combinations thereof to induce the ferroelectric layer to have an orthorhombic phase; a top electrode layer is disposed on the interfacial metal layer.

Document US 2021/151445A1 discloses a ferroelectric semiconductor device with a memory cell, with a ferroelectric memory layer and a first conductive layer disposed on the ferroelectric memory layer; and a semiconductor device connected to the memory cell.

### SUMMARY

Embodiments of the invention are set out in the appended claims.

### BRIEF DESCRIPTION OF THE DRAWINGS

Figures 1A and 1B illustrate cross-sectional views of integrated circuit (IC) structures for memory devices in accordance with various embodiments of the present disclosure.
Figure 2 illustrates an example of a computing device in accordance with various embodiments of the disclosure.
Figure 3 illustrates an example of an interposer that includes one or more embodiments of the disclosure.

### DESCRIPTION OF THE EMBODIMENTS

In the following description, memory devices with nitride-based ferroelectric materials are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions or context for terms found in this disclosure (including the appended claims):

"Comprising." This term is open-ended. As used in the appended claims, this term does not foreclose additional structure or operations.

"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active).

"First," "Second," etc. As used herein, these terms are used as labels for nouns that they precede, and do not imply any type of ordering (e.g., spatial, temporal, logical, etc.).

"Coupled" - The following description refers to elements or nodes or features being "coupled" together. As used herein, unless expressly stated otherwise, "coupled" means that one element or node or feature is directly or indirectly joined to (or directly or indirectly communicates with) another element or node or feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation or location or both of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments may be implemented to realize a 3D ferroelectric RAM (FRAM, FeRAM, or F-RAM) to potentially increase monolithic integration of backend logic plus memory in SoCs of future technology nodes. To provide context, a FRAM is a random-access memory similar in construction to DRAM but uses a ferroelectric layer instead of a dielectric layer to achieve non-volatility. Conventionally, both FRAM and DRAM are one transistor (1T)/one capacitor (1C) cell arrays, where each cell comprises an access transistor in the front end coupled to a single capacitor. The capacitor may be coupled to a bitline (COB) higher in the stack in the semiconductor back end.

As introduced above, there are a number of challenges to the scaling of features in integrated circuits. One such issue is that conventional one-transistor-one-capacitor dynamic random access memory (1T-1C DRAM) devices have a relatively low density because the capacitor, unlike a transistor, is difficult to scale due to current sensing requirements. Previous solutions to this issue include ferroelectric random access memory (FeRAM) 1T-1C architectures to form dense memory arrays. However, the 1T-1C architectures in these conventional solutions often suffer from read disturbances for memory cells sharing common bitlines.

As described in more detail below, embodiments of the present disclosure address these and other issues by providing novel memory device structures that use nitride-based ferroelectrics. Among other things, the memory devices of the present disclosure have significantly improved wakeup (e.g., near-zero wakeup) and stable remnant polarization during cycling and a sharp polarization curve relative to prior solutions. This helps to provide a memory array with an insignificant difference in switching field between devices, thereby reducing or eliminating read disturbances for devices sharing common bitlines.

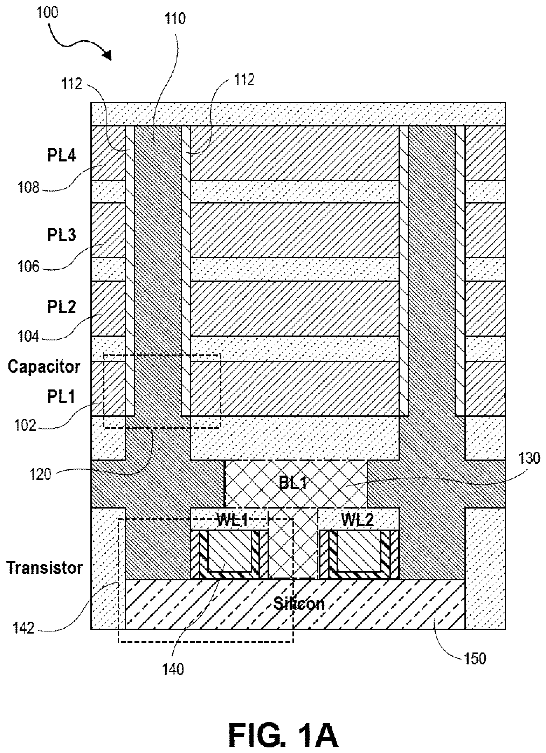

Figure 1A illustrates a cross-section view of an example of an IC structure comprising a memory device 100 in accordance with various embodiments. In this example, memory device 100 includes a node 110 and a plurality of platelines 102, 104, 106, and 108. A capacitor 120 is coupled to plateline 102, the capacitor 120 comprising a nitride-based ferroelectric material 112 between the plateline 102 and the node 110.

Embodiments of the present disclosure may operate in conjunction with any suitable nitride-based ferroelectric material or combination of materials. For example, in some embodiments, the nitride-based ferroelectric material 112 includes aluminum scandium nitride (AIScN). In some embodiments, the AlScN of the nitride-based ferroelectric material 112 includes between 25% scandium (Sc) to 40% Sc. In some embodiments, the nitride-based ferroelectric material 112 is layered in a superlattice.

The nitride-based ferroelectric material 112 may be of any suitable dimension. For example, in some embodiments the nitride-based ferroelectric material 112 has a thickness of between 3nm and 10nm. In this context, nitride-based ferroelectric material 112 has a length running substantially perpendicular to the platelines 102, 104, 106, 108 and "thickness" measured between, for example, plateline 102 and node 110. In some embodiments, the thickness may be between 3nm and 10nm for AlScN and larger (wider) for different nitride-based ferroelectrics.

Memory device 100 further includes a bitline 130 coupled to the node 110 and a wordline 140 coupled to the node110. Access transistor 142 is coupled to the bitline 130, the wordline 140, and the node 110. In the example shown in Figure 1A, the wordline 140 is perpendicular to the platelines 102, 104, 106, 108, and the bitline 130 is parallel to the platelines. In this example, memory device 100 further includes a substrate layer 150. As shown in Figure 1A, substrate layer 150 comprises silicon, though the substrate layer 150 may include any suitable material or combination of materials.

In alternate embodiments, a memory device may include a wordline that is parallel to the plateline and a bitline that is perpendicular to the plateline. In this context, "parallel" and "perpendicular" are intended to mean "substantially parallel" and "substantially perpendicular." For example, in some embodiments two structures may be substantially parallel or substantially perpendicular within +/- 5 degrees.

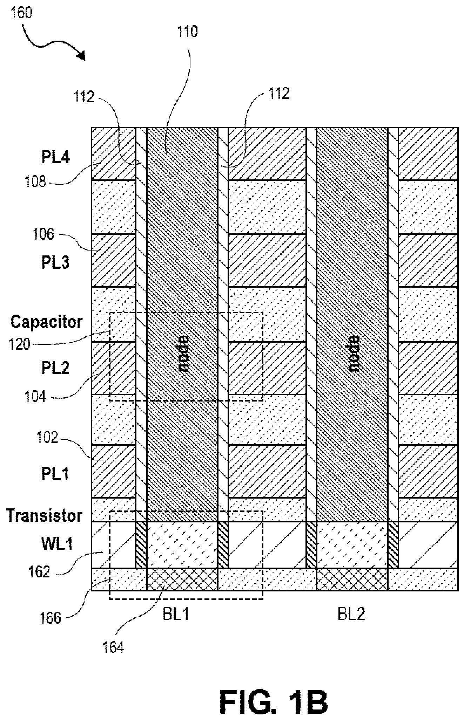

For example, Figure 1B illustrates a memory device 160 with a plurality of platelines 102, 104, 106, and 108. A capacitor 120 is coupled to plateline 102, the capacitor 120 comprising a nitride-based ferroelectric material 112 between the plateline 102 and the node 110. In this example, memory device 160 includes a wordline 162 that is parallel to the platelines 102, 104, 106, 108, and a bitline 164 that is perpendicular to platelines 102, 104, 106, 108, with access transistor 166 coupled to the wordline 162, bitline 164, and node 110 as shown.

The node 110 may comprise any suitable material or combination of materials. According to the invention, the node 110 comprises a multilayered electrode with a crystal orientation of Al(100). In other embodiments, not forming part of the invention, the node 110 may comprise a crystal orientation of Ti(111) or Pt(111).

Embodiments of the present disclosure may include any suitable number of capacitors coupled to platelines 102, 104, 106, 108. For example, plateline 102 may be coupled to a first capacitor comprising a nitride-based ferroelectric material between the first plateline 102 and the node 110, with a second capacitor 120 comprising the nitride-based ferroelectric material 112 between the second plateline 104 and the node 110.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

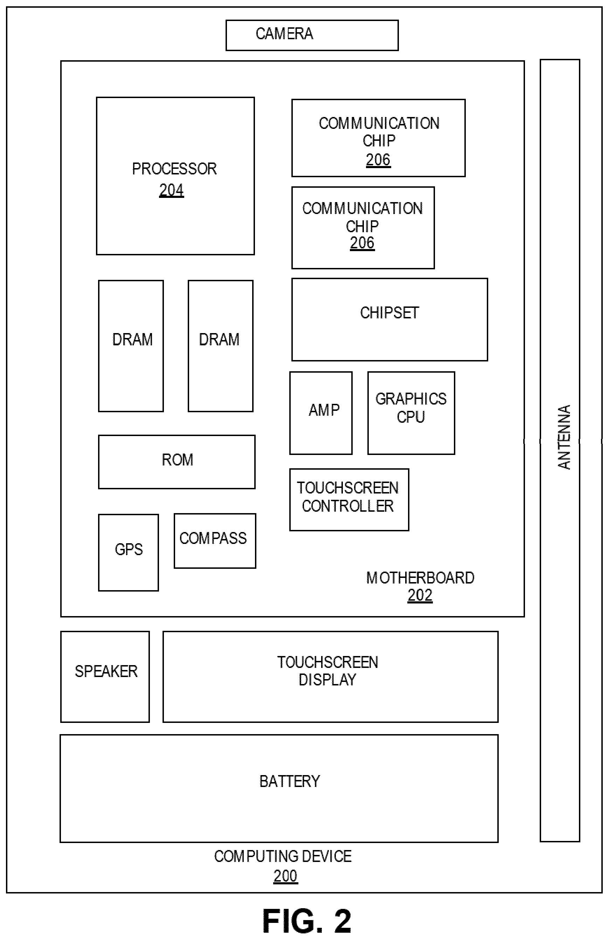

Figure 2 illustrates a computing device 200 in accordance with one implementation of the invention. The computing device 200 houses a board 202. The board 202 may include a number of components, including but not limited to a processor 204 and at least one communication chip 206. The processor 204 is physically and electrically coupled to the board 202. In some implementations the at least one communication chip 206 is also physically and electrically coupled to the board 202. In further implementations, the communication chip 206 is part of the processor 204.

Depending on its applications, computing device 200 may include other components that may or may not be physically and electrically coupled to the board 202. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 206 enables wireless communications for the transfer of data to and from the computing device 200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 206 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 200 may include a plurality of communication chips 206. For instance, a first communication chip 206 may be dedicated to shorter range wireless communications such as Wi-Fi and Bluetooth and a second communication chip 206 may be dedicated to longer range wireless communications such as GPS, EDGE, GPRS, CDMA, WiMAX, LTE, Ev-DO, and others.

The processor 204 of the computing device 200 includes an integrated circuit die packaged within the processor 204. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 206 also includes an integrated circuit die packaged within the communication chip 206. In accordance with another implementation of the invention, the integrated circuit die of the communication chip includes one or more devices, such as MOS-FET transistors built in accordance with implementations of the invention.

In further implementations, another component housed within the computing device 200 may contain an integrated circuit die that includes one or more devices, such as MOS-FET transistors built in accordance with implementations of the invention.

In various implementations, the computing device 200 may be a laptop, a netbook, a notebook, an ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In further implementations, the computing device 200 may be any other electronic device that processes data.

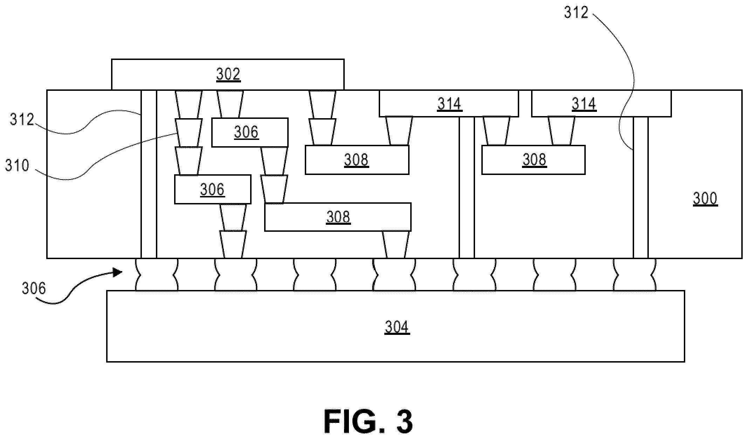

Figure 3 illustrates an interposer 300 that includes one or more embodiments of the invention. The interposer 300 is an intervening substrate used to bridge a first substrate 302 to a second substrate 304. The first substrate 302 may be, for instance, an integrated circuit die. The second substrate 304 may be, for instance, a memory module, a computer motherboard, or another integrated circuit die. Generally, the purpose of an interposer 300 is to spread a connection to a wider pitch or to reroute a connection to a different connection. For example, an interposer 300 may couple an integrated circuit die to a ball grid array (BGA) 306 that can subsequently be coupled to the second substrate 304. In some embodiments, the first and second substrates 302/304 are attached to opposing sides of the interposer 300. In other embodiments, the first and second substrates 302/304 are attached to the same side of the interposer 300. And in further embodiments, three or more substrates are interconnected by way of the interposer 300.

The interposer 300 may be formed of an epoxy resin, a fiberglass-reinforced epoxy resin, a ceramic material, or a polymer material such as polyimide. In further implementations, the interposer 300 may be formed of alternate rigid or flexible materials that may include the same materials described above for use in a semiconductor substrate, such as silicon, germanium, and other group III-V and group IV materials.

The interposer 300 may include metal interconnects 308 and vias 310, including but not limited to through-silicon vias (TSVs) 312. The interposer 300 may further include embedded devices 314, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 300. In accordance with embodiments of the invention, apparatuses or processes disclosed herein may be used in the fabrication of interposer 300.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise.

The scope of the protection conferred by the present disclosure is determined by the claims.

## Claims

1. A memory device (100, 160), comprising:
a plateline (102, 104, 106, 108);
a node (110) and
a capacitor (120) coupled to the plateline, the capacitor comprising a nitride-based ferroelectric material (112) between the plateline and the node, **characterised in that** the node comprises a multilayered electrode with a crystal orientation of Al(100).

2. The memory device of claim 1, wherein the nitride-based ferroelectric material (112) includes aluminum scandium nitride, AlScN.

3. The memory device of claim 2, wherein the AlScN of the nitride-based ferroelectric material (112) includes between 25% scandium, Sc, to 40% Sc.

4. The memory device of any of claims 1 to 3, wherein the nitride-based ferroelectric material (112) has a thickness of between 3nm and 10nm.

5. The memory device of any of claims 1 to 4, wherein the nitride-based ferroelectric material (112) is layered in a superlattice.

6. The memory device of any of claims 1 to 5, further comprising a bitline (130) coupled to the node (110).

7. The memory device of claim 6, further comprising a wordline (140) coupled to the node (110).

8. The memory device of claim 7, further comprising an access transistor (142, 166) coupled to the bitline (130), the wordline (140), and the node (110).

9. The memory device of claim 7 or 8, wherein the wordline i (140) is perpendicular to the plateline (102, 104, 106, 108) and the bitline (130) is parallel to the plateline.

10. The memory device of any of claims 7 or 8, wherein the wordline (140) is parallel to the platelini (102, 104, 106, 108) and the bitline (130) is perpendicular to the plateline.

11. A method of fabricating a memory device (100), the method comprising:
forming a plateline (102, 104, 106, 108);
forming a node (110) and
forming a capacitor (120) coupled to the plateline, the capacitor comprising a nitride-based ferroelectric material (112) between the plateline and the node, **characterised in that**
the node comprises a multilayered electrode with a crystal orientation of Al(100).

12. The method of claim 11, wherein the nitride-based ferroelectric material (112) includes aluminum scandium nitride, AlScN.

13. The method of claim 12, wherein the AlScN of the nitride-based ferroelectric material (112) includes between 25% scandium, Sc, to 40% Sc.

## Patentansprüche

1. Speichervorrichtung (100, 160), umfassend:
eine Plattenleitung (102, 104, 106, 108);
einen Knoten (110), und
einen Kondensator (120),
der mit der Plattenleitung gekoppelt ist, wobei der Kondensator ein nitridbasiertes ferroelektrisches Material (112) zwischen der Plattenleitung und dem Knoten umfasst, **dadurch gekennzeichnet, dass** der Knoten eine Mehrschichtelektrode mit einer Kristallorientierung von Al(100) umfasst.

2. Speichervorrichtung nach Anspruch 1, wobei das nitridbasierte ferroelektrische Material (112) Aluminiumscandiumnitrid, AlScN, aufweist.

3. Speichervorrichtung nach Anspruch 2, wobei das AlScN des nitridbasierten ferroelektrischen Materials (112) zwischen 25 % Scandium, Sc, bis 40 % Sc aufweist.

4. Speichervorrichtung nach einem der Ansprüche 1 bis 3, wobei das nitridbasierte ferroelektrische Material (112) eine Dicke zwischen 3 nm und 10 nm aufweist.

5. Speichervorrichtung nach einem der Ansprüche 1 bis 4, wobei das nitridbasierte ferroelektrische Material (112) in einem Supergitter geschichtet ist.

6. Speichervorrichtung nach einem der Ansprüche 1 bis 5, ferner umfassend eine Bitleitung (130), die mit dem Knoten (110) gekoppelt ist.

7. Speichervorrichtung nach Anspruch 6, ferner umfassend eine Wortleitung (140), die mit dem Knoten (110) gekoppelt ist.

8. Speichervorrichtung nach Anspruch 7, ferner umfassend einen Zugriffstransistor (142, 166), der mit der Bitleitung (130), der Wortleitung (140) und dem Knoten (110) gekoppelt ist.

9. Speichervorrichtung nach Anspruch 7 oder 8, wobei die Wortleitung (140) senkrecht zu der Plattenleitung (102, 104, 106, 108) ist und die Bitleitung (130) parallel zu der Plattenleitung ist.

10. Speichervorrichtung nach einem der Ansprüche 7 oder 8, wobei die Wortleitung (140) parallel zu der Plattenleitung (102, 104, 106, 108) ist und die Bitleitung (130) senkrecht zu der Plattenleitung ist.

11. Verfahren zur Herstellung einer Speichervorrichtung (100), wobei das Verfahren umfasst:
Bilden einer Plattenleitung (102, 104, 106, 108);
Bilden eines Knotens (110), und
Bilden eines Kondensators (120),
der mit der Plattenleitung gekoppelt ist, wobei der Kondensator ein nitridbasiertes ferroelektrisches Material (112) zwischen der Plattenleitung und dem Knoten umfasst, **dadurch gekennzeichnet, dass** der Knoten eine Mehrschichtelektrode mit einer Kristallorientierung von Al(100) umfasst.

12. Verfahren nach Anspruch 11, wobei das nitridbasierte ferroelektrische Material (112) Aluminiumscandiumnitrid, AlScN, aufweist.

13. Verfahren nach Anspruch 12, wobei das AlScN des nitridbasierten ferroelektrischen Materials (112) zwischen 25 % Scandium, Sc, bis 40 % Sc aufweist.

## Revendications

1. Dispositif de mémoire (100, 160) comprenant :
une ligne de polarisation (102, 104, 106, 108) ;
un nœud (110) et
un condensateur (120)
couplés à la ligne de polarisation, le condensateur comprenant un matériau ferroélectrique à base de nitrure (112) situé entre la ligne de polarisation et le nœud, **caractérisé en ce que** le nœud comprend une électrode multicouche présentant une orientation cristalline d'Al(100).

2. Dispositif de mémoire selon la revendication 1, dans lequel le matériau ferroélectrique à base de nitrure (112) comprend du nitrure d'aluminium et de scandium, AlScN.

3. Dispositif de mémoire selon la revendication 2, dans lequel l'AlScN du matériau ferroélectrique à base de nitrure (112) comprend entre 25 % de scandium, Sc, et 40 % de Sc.

4. Dispositif de mémoire selon l'une quelconque des revendications 1 à 3, dans lequel le matériau ferroélectrique à base de nitrure (112) a une épaisseur comprise entre 3 nm et 10 nm.

5. Dispositif de mémoire selon l'une quelconque des revendications 1 à 4, dans lequel le matériau ferroélectrique à base de nitrure (112) est stratifié en un super-réseau.

6. Dispositif de mémoire selon l'une quelconque des revendications 1 à 5, comprenant en outre une ligne de bits (130) couplée au nœud (110).

7. Dispositif de mémoire selon la revendication 6, comprenant en outre une ligne de mots (140) couplée au nœud (110).

8. Dispositif de mémoire selon la revendication 7, comprenant en outre un transistor d'accès (142, 166) couplé à la ligne de bits (130), à la ligne de mots (140) et au nœud (110).

9. Dispositif de mémoire selon la revendication 7 ou la revendication 8, dans lequel la ligne de mots (140) est perpendiculaire à la ligne de polarisation (102, 104, 106, 108) et la ligne de bits (130) est parallèle à la ligne de polarisation.

10. Dispositif de mémoire selon l'une quelconque des revendications 7 ou 8, dans lequel la ligne de mots (140) est parallèle à la ligne de polarisation (102, 104, 106, 108) et la ligne de bits (130) est perpendiculaire à la ligne de polarisation.

11. Procédé de fabrication d'un dispositif de mémoire (100), le procédé comprenant les étapes suivantes :
former une ligne de polarisation (102, 104, 106, 108) ;
former un nœud (110) et
former un condensateur (120)
couplés à la ligne de polarisation, le condensateur comprenant un matériau ferroélectrique à base de nitrure (112) situé entre la ligne de polarisation et le nœud, **caractérisé en ce que** le nœud comprend une électrode multicouche présentant une orientation cristalline d'Al(100).

12. Procédé selon la revendication 11, dans lequel le matériau ferroélectrique à base de nitrure (112) comprend du nitrure d'aluminium et de scandium, AlScN.

13. Procédé selon la revendication 12, dans lequel l'AlScN du matériau ferroélectrique à base de nitrure (112) comprend entre 25 % de scandium, Sc, et 40 % de Sc.
